# EUROPÄISCHE PATENTSCHRIFT

(11) **EP 0 318 641 B1**
(45) Veröffentlichungstag und Bekanntmachung des Hinweises auf die Patenterteilung: **27.10.1993**
(21) Anmeldenummer: 88112869.8
(22) Anmeldetag: 08.08.1988
(51) Int. Cl.: H01L 21/00

(54) **Verfahren und Vorrichtung zur Übertragung thermischer Energie auf bzw. von einem plattenförmigen Substrat**
Process and device for the transmission of thermal energy to or from a plate-like substrate
Procédé et dispositif de transmission d'énergie thermique vers ou d'un substrat en forme de plaque

(30) Priorität: 03.12.1987 CH 4747/87
(43) Veröffentlichungstag der Anmeldung: 07.06.1989
(73) Patentinhaber: BALZERS AKTIENGESELLSCHAFT, 9496 Balzers (LI)
(72) Erfinder: Hirscher, Hans, Dr., CH-7310 Bad Ragaz (CH); Wagner, Rudolf, CH-9476 Fontnas (CH)

(56) Entgegenhaltungen:
- GB-A- 2 137 664

## Beschreibung

Die Erfindung bezieht sich auf ein Verfahren zum Erzielen eines Wärmeübergangs zwischen einem plattenförmigen Objekt und einer Trägervorrichtung.

Sie bezieht sich insbesondere auf ein Verfahren zur Uebertragung von Wärmeenergie zwischen Träger und plattenförmigen Objekt bzw. Plättchen, bei der ein Gas zwischen Plättchen und Trägervorrichtung eingeführt wird um diesen Uebergang von Wärme zu verbessern, und bei der das gleiche Gas dazu dient, das Plättchen auf der Trägervorrichtung anzupressen.

Bei der Verarbeitung von plattenförmigen Objekten beispielsweise in der Vakuumtechnik, namentlich von Halbleiterplättchen werden diese häufig auf erhöhte Temperaturen aufgeheizt. Dabei ist es wünschenswert, die Wärmeenergie in gesteuerter und homogener Weise aufzubringen. In anderen Fällen ist es erforderlich, die Plättchen auf kontrollierte und gleichmässige Weise abzukühlen.

Im Stand der Technik ist dieser Wärmeübergang durch Strahlung, konvektive und konduktive Massnahmen zu verbessern gesucht worden. Eine konvex gekrümmte Aufspannplatte, an der ein Halbleiterplättchen festgehalten ist, ist in US-PS 4 282 924 angegeben worden. Die Kühl- oder Heizleistung dieser Vorrichtung ist durch das Ausmass, in welchem die Rückseite des Plättchens tatsächlich mit der wärmeleitenden Oberfläche in Berührung steht, begrenzt, da auf mikroskopischem Niveau nur kleine Bereiche der beteiligen Oberfläche (typischerweise weniger als 5 %) tatsächlich miteinander in Berührung steht.

Von der Technik der Gasleitung ist bekannt, dass sie eine sogenannte Wärmekopplung zwischen zwei einander benachbarten Oberflächen ermöglicht.

In GB-A- 2 137 664 ist eine solche Vorrichtung, bei welcher eine Wärmekopplung zwischen einer Trägervorrichtung und einem Halbleiterplättchen mittels Gaskontakt erziehlt wird, aufgezeigt. Bei der dargestellten Anordnung wird ein Halbleiterplättchen gegen eine flache Trägervorrichtung gehalten wobei diese geheizt oder gekühlt werden kann. Zur Herstellung eines Wärmeüberganges wird Gas unter Druck zwischen die Trägervorrichtung und das Halbleiterplättchen eingelassen, wobei das Gas durch eine Zuleitung im Zentrum der Trägervorrichtung zugeführt wird. Für eine gute Wärmeleitung sind genügend hohe Drücke notwendig, empfohlen werden Drücke im Bereich von 100 bis 1000 micrometers wobei der Umgebungsdruck in der Kammer 10 bis 100 mal geringer ist. Durch diese Druckbeaufschlagung wird wie dies in der DE-OS 33 17 967 ausführlich erläutert wird, das Plättchen membranartig von der Trägerplatte wegbewegt wodurch sich der Abstand vergrössert und der Wärmeübergang wieder verschlechtert wird. In US-PS 4 457 359 = DE-OS 33 17 967 sind diese Vorteile des Wärmeübergangs durch Gasleitung mit demjenigen des Wärmeübergangs durch Festkörperkontakt kombiniert worden. Zu diesem Zweck wird eine konvexe Rückplatte verwendet und das Halbleiterplättchen mit einer Spannvorrichtung am Rande dieser Rückplatte vorgespannt, so dass ein hoher Gasdruck verwendet werden kann ohne das Halbleiterplättchen zu verwölben.

Dadurch wird trotz optimal eingesetztem Gasdruck der kleinstmögliche Abstand zwischen Plättchen und Rückplatte durch die Vorwölbung beibehalten. Der Nachteil dieser Erfindung besteht indessen darin, dass eine derartige Durchwölbung des Plättchens etwa für Siliziumwafer mit einem Durchmesser von > 4 '' nicht akzeptiert werden darf, da sie zu Bruchgefahr, Stresszuständen in der Schicht und Toleranzproblemen in der Mikrostruktur der fertigen Erzeugnisse führt.

Aufgabe der Erfindung ist es daher, für den Uebergang von Wärme zwischen Rückplatte und Plättchen die Vorteile des Wärmeüberganges durch Gasleitung voll auszunutzen und dabei die Nachteile einer mechanischen Belastung durch Vorwölbung und Vorspannung des Plättchens zu vermeiden.

Diese Aufgabe wird durch ein Verfahren gemäss den im Patentanspruch 1 beschriebenen Merkmalen gelöst.

Mit der Erfindung wird also ein Gas sowohl als sogenanntes Gaspolster zur Verbesserung des Wärmeübergangs zwischen Plättchen und Rückplatte als auch zum Anpressen des Plättchens auf diese Rückplatte unter Vermeidung einer mechanischen Biege Belastung desselben eingesetzt. Da dabei der Spalt zwischen Plättchen und Rückplatte klein bleibt, wird der Wärmewiderstand reduziert und der Wärmeübergang verbessert.

Eine Vorrichtung zur Durchführung des Verfahrens wird nachstehend mit weiteren vorteilhaften Einzelheiten anhand von schematisch dargestellten Ausführungsbeispielen näher erläutert, ist indessen nicht auf diese besonderen Ausführungsformen beschränkt.

Dabei zeigen:
- Fig. 1: einen Querschnitt durch eine Vorrichtung zur Durchführung des erfinderischen Verfahrens.
- Fig. 2: einen Querschnitt durch eine vergrösserte Einzelheit der Vorrichtung zur Durchführung des erfinderischen Verfahrens.

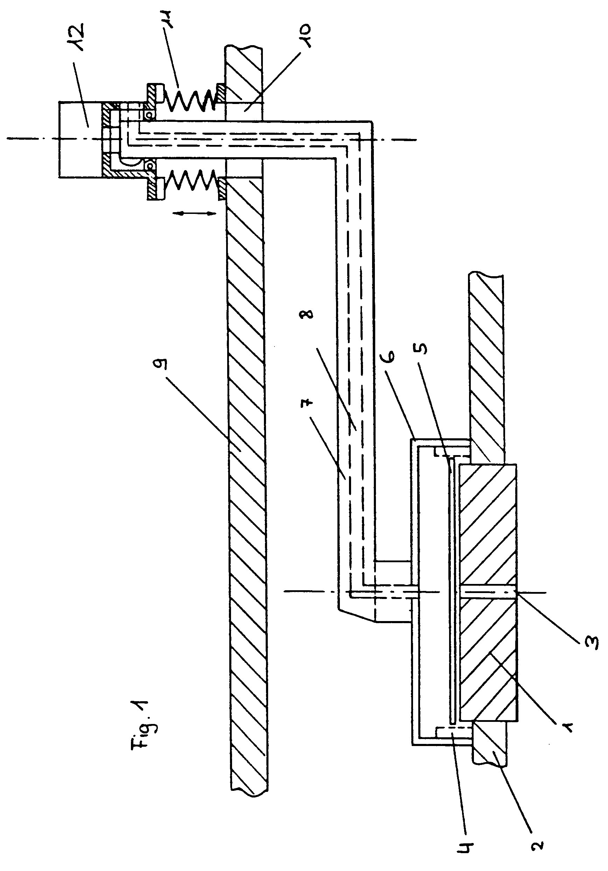

In dem Ausführungsbeispiel nach Figur 1 ist eine plane Trägervorrichtung die Rückplatte 1 in der Grundplatte 2 verankert. Diese Rückplatte weist eine von der Temperatur des plattenförmigen Objekts 5, beispielsweise einem Siliziumwafer, verschiedene Temperatur auf, kann also je nach Aufgabenstellung als Heiz- oder Kühlplatte ausgebildet sein. Auf dieser Rückplatte 1 liegt das Plättchen 5 auf, wobei bei einem Siliziumwafer auf Grund der Körnung der beiden Werkstoffe nur kleine Bereiche der beiden Oberflächen (typischerweise weniger als 5 %) tatsächlich miteinander in Kontakt stehen und dazwischen ein Zwischenraum gebildet wird, in den durch eine Bohrung 3 ein Gas eingeleitet werden kann. Dabei stellt sich bei entsprechendem Gasdruck in diesem Zwischenraum mindestens teilweise eine molekulare Strömung des Gases ein, das heisst, die freie Weglänge der Gaspartikel ist gross im Verhältnis zur Geometrie der Umgebung und die Gaspartikel stossen daher bevorzugt an den Oberflächen von Plättchen 5 und Rückplatte 1, nicht aber mit anderen Gaspartikel zusammen.

Vorteilhafterweise wird das Plättchen 5 durch Zentrierstifte 4 in eine vorbestimmte Position gebracht.

Ein Deckel 6 wird mechanisch auf die Grundplatte angepresst und schliesst Plättchen 5 und Rückplatte 1 gegen die Umgebung ab, welche typischerweise einen Gasdruck von 10⁻³ bis 10⁻⁴ mbar aufweist. Dabei wird es in vielen Fällen genügen, wenn ein sogenannter Diffusionsspalt zwischen Deckel 6 und Grundplatte 2 gebildet wird. Dieser Deckel 6 kann an einem Dreharm 7 in vertikaler Richtung und in horizontaler Richtung verschoben werden. Dieser Dreharm 7 ist seinerseits mit einer Durchführung 10 an einem zweiten Boden 9 verankert und mit einem integrierten Drehhubelement 11 und 12 verbunden. Durch Betätigen des Hubelementes 11 kann der Deckel in vertikaler Richtung verschoben und namentlich von der Grundplatte 2 abgehoben werden. Durch Drehung um die Längsachse des Drehelementes 12 kann er in horizontaler Richtung verschoben, namentlich über das fragliche Plättchen 5 gefahren werden.

Drehachse 7 und Deckel 6 weisen entsprechende Bohrungen für das Einleiten eines Gases auf.

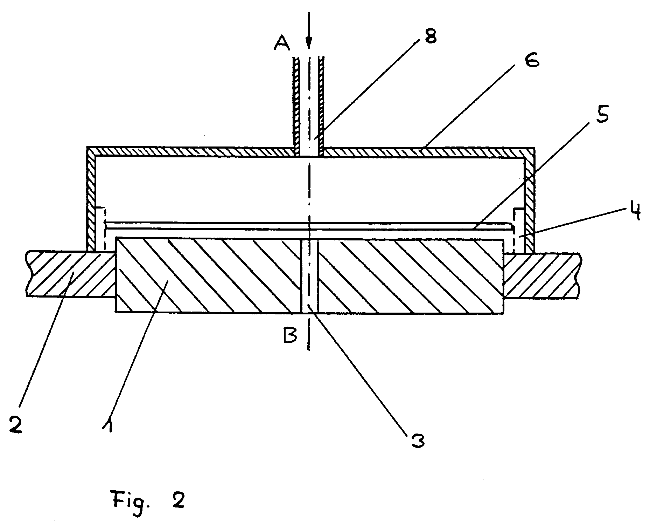

Figur 2 zeigt die nähere Umgebung des Plättchens 5 und der Rückplatte 1 zwischen denen der Wärmeübergang stattfindet. Durch eine Dosiervorrichtung bekannter Bauart wird an den Stellen A und B gleichzeitig Gas eingeleitet und die Druckverhältnisse derart geregelt, dass der Druck zwischen Deckel 6 und Plättchen 5 ein Vielfaches des Druckes zwischen Rückplatte 1 und Plättchen 5 beträgt.Dazu müssen die Leitwerte der Gaszuleitungen zu der Plättchenvorderseite sowie in den Raum zwischen Plättchenrückseite und Rückplatte derart dimensioniert werden, dass die Plättchenvorderseite mit einem höheren Druck beaufschlagt wird, vorzugsweise 50 mbar Anpressdruck bei einem Druck des "Gaspolsters" von vorzugsweise 15 mbar. Dadurch wird das Plättchen 5 in optimaler Weise in Kontakt mit der Rückplatte 1 gebracht ohne, dass dabei eine mechanische Biege Belastung des Plättchens 5 eintritt. Dabei ist zu berücksichtigen, dass die Oberfläche von standardmässigen, nichtpolierten Siliziumwaferrückseiten Krater von ca. 10 µm Durchmesser und ca. 5 µm Tiefe aufweisen, die auch mit grösseren Anpressdrücken nicht in direktem Kontakt mit der Rückplatte gebracht werden könnten.

In einer verfahrensmässigen Variante kann ein entsprechendes Druckverhältnis auch dadurch erzielt werden, dass das Gas nur bei A eingeleitet wird und über die Ränder des Plättchens 5 in den Zwischenraum zu der Rückplatte 1 eintritt und die Vorrichtung bei B verlässt.

Wird die Rückplatte 1 als Heizplatte eingesetzt so kann es vorteilhaft sein, die Temperatur in deren Zentrum höher einzustellen als an deren Peripherie, so dass ein Temperaturgradient in der Heizplatte entsteht. Das kann beispielsweise dadurch bewirkt werden, dass die Heizdrähte verschieden dicht gewickelt werden oder dass zwei separat regelbare Heizdrahtsysteme in der Platte vorgesehen werden.

Die Vorrichtung wird typischerweise in folgenden Verfahrensschritten eingesetzt: Das Plättchen 5 wird mit Hilfe der Zentrierstifte 4 auf der Rückplatte 1 placiert. Der Deckel 6 wird mechanisch auf der Grundplatte 2 angepresst und Gas durch die Bohrungen 3 und 8 ein- bzw. abgeleitet derart, dass sich das bereits erwähnte Druckverhältnis (vorzugweise 3:1 bis 10:1) einstellt. Das Plättchen 5 wird während einer vorbestimmten Zeit, beispielsweise einigen Sekunden, auf der Rückplatte 1 belassen, bis es die gewünschte Temperatur angenommen hat.

Anschliessend wird der Deckel 6 wieder abgehoben und dadurch der Druckausgleich mit der Umgebung, typischerweise 10⁻³ bis 10⁻⁵ mbar erzielt. Schliesslich kann das Plättchen 5, welches nunmehr die gewünschte Temperatur aufweist, der weiteren Bearbeitung zugeführt werden.

### Beispiel 1

In einer typischen Versuchsanordnung wurden Siliziumwafer für die Produktion von Mikroprozessoren in einem Zeitintervall von 10 bis 15 Sekunden auf 500° C aufgeheizt. Der Druck zwischen Deckel und Plättchen betrug dabei 50 mbar, derjenige zwischen Plättchen und Rückplatte 15 mbar. Die Vorrichtung wurde in einer Anlage zur Kathodenzerstäubung mit einem Umgebungsdruck von 10⁻³ mbar betrieben und das verwendete Prozessgas war dabei Argon von handelsübliche Zusammensetzung.

## Patentansprüche

1. Verfahren zur Erreichung des Wärmeüberganges zwischen einem plattenförmigen Objekt (5) und einer planen Trägervorrichtung (1) in Vakuum wobei
- das plattenförmige Objekt (5) auf die Trägervorrichtung (1) placiert wird,
- ein Deckel (6) über dem Objekt (5) mechanisch auf eine mit der Trägervorrichtung (1) verbundene Grundplatte (2) angepresst wird,
- ein Gas zwischen Deckel (6) und Objekt (5) und zwischen Objekt (5) und Trägervorrichtung (1) eingeleitet wird,
- der Gasdruck derart eingestellt wird, dass der Druck zwischen Deckel (6) und Objekt (5) denjenigen zwischen Objekt (5) und Trägervorrichtung (1) übersteigt, so dass das Objekt (5) an die plane Trägervorrichtung (1) angepresst wird,
- der Trägervorrichtung (1) eine vorbestimmte Temperatur verliehen wird,
- das Objekt (5) während einer vorbestimmten Zeit in dieser Stellung belassen wird, bis es eine vorbestimmte Temperatur aufweist,
- der Deckel (6) wieder von der Grundplatte (2) entfernt wird und dadurch ein Druckausgleich mit der Umgebung erzielt wird, und
- das Objekt (5) einer weiteren Bearbeitung zugeführt wird.

2. Verfahren nach Anspruch 1, **dadurch gekennzeichnet**, dass sowohl durch den Deckel (6) als auch durch die Trägervorrichtung (1) Gas eingeleitet wird.

3. Verfahren nach Anspruch 1, **dadurch gekennzeichnet,** dass das Gas durch den Deckel (6) eingeleitet und durch die Trägervorrichtung (1) abgeleitet wird.

4. Verfahren nach Anspruch 2 oder 3, **dadurch gekennzeichnet**, dass das Verhältnis zwischen dem Druck im Bereich zwischen Deckel (6) und Objekt (5) und demjenigen im Bereich zwischen Objekt (5) und Trägervorrichtung (1) zwischen 3 und 10 beträgt.

5. Verfahren nach einem der vorhergehenden Ansprüche, **dadurch gekennzeichnet**, dass der Druck zwischen Deckel (6) und Objekt (5) 15 bis 50 mbar beträgt und das Objekt (5) 10 bis 20 Sekunden auf der Trägervorrichtung (1) der Temperatureinwirkung ausgesetzt wird.

## Claims

1. Method to reach a transmission of heat between a plate-like object (5) and a planar carrier (1) in a vacuum where:
- the plate-like object (5) is placed on the carrier (1),
- a cover (6) above the object (5) is mechanically pressed to a base plate (2) linked to the carrier (1),
- a gas is let in between cover (6) and object (5) and between object (5) and carrier (1),
- the gas pressure being such that the pressure between cover (6) and object (5) is higher than the one between object (5) and carrier (1) so that the object (5) is being pressed onto the planar carrier (1),
- the carrier (1) is heated to a predetermined temperature,
- the object (5) is left in this position during a predetermined period until it reaches a predetermined temperature,
- the cover (6) is removed from the base plate (2) which leads to a pressure compensation with the surrounding and,
- the object (5) is lead to further treatment

2. Method according to claim 1 **characterized in that** the gas is let in through the cover (6) as well as through the carrier (1).

3. Method according to claim 1 **characterized in that** the gas is let in through the cover (6) and then is let off through the carrier (1).

4. Method according to claim 2 or 3 **characterized in that** the ratio between the pressure in the region between cover (6) and object (5) and the one in the region between object (5) and carrier (1) is between 3 and 10.

5. Method according to one of the preceeding claims **characterized in that** the pressure between cover (6) and object (5) is between 15 to 50 mbar and the object (5) on the carrier (1) is exposed to the temperature treatment during 10 to 20 seconds.

## Revendications

1. Procédé de réalisation du transfert de chaleur sous vide entre un objet (5) en forme de plaque et un dispositif porteur plan (1), dans lequel
- l'objet en forme de plaque (5) est placé sur le dispositif porteur (1),
- un couvercle (6) au-dessus de l'objet (5) est appuyé mécaniquement sur une plaque de base (2) reliée au dispositif porteur (1),
- un gaz est introduit entre le couvercle (6) et l'objet (5) et entre l'objet (5) et le dispositif porteur (1),
- la pression gazeuse est réglée d'une manière telle que la pression entre le couvercle (6) et l'objet (5) dépasse celle entre l'objet (5) et le dispositif porteur (1) de sorte que l'objet (5) est appuyé sur le dispositif porteur plan (1)
- une température prédéterminée est communiquée au dispositif porteur (1)
- l'objet (5) est laissé pendant un temps prédéterminé dans cette position, jusqu'à ce qu'il présente la température prédéterminée
- le couvercle (6) est à nouveau écarté de la plaque de base (2) et de cette manière une compensation de pression avec l'environnement est atteinte, et
- l'objet (5) est amené à un traitement ultérieur.

2. Procédé selon la revendication 1 caractérisé en ce qu'un gaz est introduit tant à travers le couvercle (6) qu'à travers le dispositif porteur (1).

3. Procédé selon la revendication 1 caractérisé en ce qu'un gaz est introduit à travers le couvercle (6) et évacué à travers le dispositif porteur (1).

4. Procédé selon la revendication 2 ou 3, caractérisé en ce que le rapport entre la pression dans la zone comprise entre le couvercle (6) et l'objet (5) et la pression dans la zone comprise entre l'objet (5) et le dispositif porteur (1) est compris entre 3 et 10.

5. Procédé selon l'une des revendications précédentes caractérisé en ce que la pression entre le couvercle 6 et l'objet (5) est de 15 à 50 mbar et en ce que l'objet (5) est exposé 10 à 20 secondes à l'effet de la température sur le dispositif porteur (1).
